(19) Europäisches Patentamt
European Patent Office
Office européen des brevets

(11) **EP 3 127 747 A1**

(12) **DEMANDE DE BREVET EUROPEEN**

(43) Date de publication:
**08.02.2017 Bulletin 2017/06**

(51) Int Cl.:
*B60Q 1/28* (2006.01)    *F21S 8/10* (2006.01)
*H01L 33/08* (2010.01)    *H01L 33/24* (2010.01)
*F21Y 105/00* (2016.01)    *F21Y 105/10* (2016.01)
*F21Y 105/12* (2016.01)

(21) Numéro de dépôt: **16182819.9**

(22) Date de dépôt: **04.08.2016**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **07.08.2015 FR 1557617**

(71) Demandeur: **VALEO VISION**
**93012 Bobigny Cedex (FR)**

(72) Inventeurs:
• **REISS, Benoit**
  **95580 MAGENCY (FR)**
• **ALBOU, Pierre**
  **75013 PARIS (FR)**
• **PAUTY, Etienne**
  **93170 BAGNOLET (FR)**
• **SANCHEZ, Vanesa**
  **92270 BOIS COLOMBES (FR)**
• **DE LAMBERTERIE, Antoine**
  **75019 PARIS (FR)**
• **LE-CALVEZ, Gilles**
  **92500 RUEIL-MALMAISON (FR)**

(54) **DISPOSITIF D'ÉCLAIRAGE ET/OU DE SIGNALISATION POUR VÉHICULE AUTOMOBILE**

(57)   Un dispositif lumineux pour véhicule automobile comporte au moins deux sources de lumière (4, 6) à semi-conducteur activables sélectivement et au moins une optique de mise en forme d'au moins une partie des rayons lumineux émis par l'une et/ou l'autre des sources de lumière en vue de générer au moins deux fonctions d'éclairage et/ou de signalisation.

Le dispositif est configuré de telle sorte qu'une première fonction nécessite l'activation de la première source de lumière à semi-conducteur (4) et qu'une deuxième fonction nécessite l'activation de la deuxième source de lumière à semi-conducteur (6).

Au moins une des sources de lumière (4) est une source de lumière à semi-conducteur comprenant des bâtonnets électroluminescents.

Fig. 1

EP 3 127 747 A1

Fig. 2

## Description

L'invention a trait au domaine de l'éclairage, intérieur et/ou extérieur, et/ou de la signalisation, notamment pour véhicules automobiles. Elle concerne plus particulièrement un dispositif apte à générer deux fonctions distinctes d'éclairage et/ou de signalisation par activation sélective de deux sources de lumière.

Un véhicule automobile est équipé de projecteurs, ou phares, destinés à illuminer la route devant le véhicule, la nuit ou en cas de luminosité réduite. Ces projecteurs peuvent généralement être utilisés selon deux modes d'éclairage : un premier mode « feux de route » et un deuxième mode « feux de croisement ». Le mode « feux de route » permet d'éclairer fortement la route loin devant le véhicule. Le mode « feux de croisement » procure un éclairage plus limité de la route, mais offrant néanmoins une bonne visibilité, sans éblouir les autres usagers de la route. Ces deux modes d'éclairage sont complémentaires, et l'on passe de l'un à l'autre en fonction des conditions de circulation. La commutation d'un mode à l'autre peut se faire manuellement, le conducteur décidant du moment de cette commutation, ou elle peut se faire automatiquement, en fonction de la détection par des moyens appropriés de conditions requises à un tel changement de mode d'éclairage. Chaque fonction d'éclairage peut être assurée par un module, et les différents modules sont disposés côte à côte dans le projecteur. Toutefois, notamment pour des questions de confort visuel pour le conducteur, de coût de revient, et d'esthétique, les constructeurs souhaitent proposer des projecteurs dans lesquels un module est apte à réaliser alternativement l'une ou l'autre des fonctions, afin que le faisceau lumineux correspondant sorte par la même face de sortie optique. On comprend que cette problématique s'applique quelle que soit la combinaison de fonctions d'éclairage que l'on souhaite mettre en place.

Par ailleurs, dans les dispositifs lumineux de véhicules automobiles, les sources de lumière sont de plus en plus fréquemment constituées par des diodes électroluminescentes, notamment pour des avantages d'encombrement et d'autonomie par rapport à des sources de lumière classiques. L'utilisation de diodes électroluminescentes dans les modules lumineux a permis en outre aux acteurs du marché (fabricant d'automobiles et concepteur de dispositifs lumineux) d'apporter une touche créative à la conception de ces dispositifs, notamment par l'utilisation d'un nombre toujours plus grand de ces diodes électroluminescentes pour réaliser des effets optiques. Un des inconvénients à l'utilisation de ces diodes est leur coût de revient.

Dans ce double contexte, on sait associer soit une diode électroluminescente (LED) comportant deux émetteurs (LED double chip) dans lequel chaque émetteur est adressable individuellement, soit deux diodes électroluminescentes distinctes disposées à proximité l'une de l'autre.

Dans les deux cas, une séparation non négligeable est prévue entre les deux émetteurs, cette séparation pouvant par exemple représenter 8 à 12% de la taille de la puce, ce qui peut se traduire par une séparation angulaire entre les faisceaux code et route.

Dans ce double contexte, l'invention a pour objet un dispositif lumineux pour véhicule automobile, comprenant au moins deux sources de lumière à semi-conducteur activables sélectivement et au moins une optique de mise en forme d'au moins une partie des rayons lumineux émis par l'une et/ou l'autre des sources de lumière en vue de générer au moins deux fonctions d'éclairage et/ou de signalisation.

Par dispositif lumineux, on entend aussi bien un dispositif d'éclairage intérieur, un dispositif d'éclairage extérieur, un dispositif de signalisation ou un dispositif pouvant combiner éclairage extérieur et signalisation. Et par ailleurs, par optique de mise en forme, on entend des moyens permettant de changer la direction d'au moins une partie des rayons lumineux.

Selon un aspect de l'invention, le dispositif est configuré de telle sorte qu'une première fonction nécessite l'activation de la première source de lumière à semi-conducteur et qu'une deuxième fonction nécessite l'activation de la deuxième source de lumière à semi-conducteur, au moins une des sources de lumière à semi-conducteur activables sélectivement étant une source de lumière à semi-conducteur comprenant des bâtonnets électroluminescents de dimensions submillimétriques.

Selon un aspect de l'invention, on applique au domaine automobile une technologie consistant à réaliser la zone émettrice de lumière par une forêt de bâtonnets électroluminescents de dimensions submillimétriques que l'on fait croître sur un substrat, pour réaliser une topologie en trois dimensions. On comprend que cette topologie en trois dimensions présente l'avantage de multiplier la surface d'émission lumineuse par rapport aux diodes électroluminescentes connues jusque-là dans le domaine de l'automobile, à savoir des diodes sensiblement planes. De la sorte, il est possible, à partir de deux sources distinctes et d'un unique réflecteur et en utilisant pour au moins une des deux sources de lumière, une source comportant des bâtonnets électroluminescents de dimensions submillimétriques, de générer une double fonction d'éclairage, l'utilisation d'au moins une source de lumière comportant des bâtonnets électroluminescents permettant de prévoir une zone spécifique à la création d'un faisceau Route dont la luminance est plus élevée que la luminance d'une zone spécifique à la création d'un faisceau Code.

Selon différents aspects de l'invention, on prévoit que :

- la deuxième fonction d'éclairage et/ou de signalisation nécessite uniquement l'activation de la deuxième source de lumière à semi-conducteur ; dans ce cas, la deuxième fonction d'éclairage et/ou de signalisation peut consister en la formation d'un faisceau de feu de type antibrouillard, ou bien la formation d'un faisceau de feu de type code.

- la deuxième fonction d'éclairage et/ou de signalisation nécessite l'activation simultanée de la première source de lumière à semi-conducteur et de la deuxième source de lumière à semi-conducteur ; dans ce cas, on pourra prévoir que la deuxième fonction d'éclairage et/ou de signalisation consiste en la formation d'un faisceau de feu de type route, et que la première fonction d'éclairage et/ou de signalisation consiste en la formation d'un faisceau de feu de type code.

Les bâtonnets électroluminescents peuvent s'étendre à partir d'un même substrat, et ils peuvent notamment être formés directement sur ce substrat. On peut prévoir que le substrat soit à base de Silicium ou de carbure de silicium. On comprend que le substrat est à base de silicium dès lors qu'il comporte majoritairement du silicium, par exemple au moins 50% et dans la pratique environ 99%.

Selon des caractéristiques propres à la constitution des bâtonnets électroluminescents et à la disposition de ces bâtonnets électroluminescents sur le substrat, on pourra prévoir que, chaque caractéristique pouvant être prise seule ou en combinaison avec les autres :

- chaque bâtonnet présente une forme générale cylindrique, notamment de section polygonale ; on pourra prévoir que chaque bâtonnet est la même forme générale, et notamment une forme hexagonale ;

- les bâtonnets sont chacun délimités par une face terminale et par une paroi circonférentielle qui s'étend le long d'un axe longitudinal du bâtonnet définissant sa hauteur, la lumière étant émise au moins à partir de la paroi circonférentielle ; cette lumière pourrait également être émise par la face terminale ;

- chaque bâtonnet peut présenter une face terminale qui est sensiblement perpendiculaire à la paroi circonférentielle, et dans différentes variantes, on peut prévoir que cette face terminale est sensiblement plane ou bombée, ou pointue, en son centre ;

- les bâtonnets sont agencés en matrice, que cette matrice soit régulière, avec un espacement constant entre deux bâtonnets successifs d'un alignement donné, ou que les bâtonnets soient disposés en quinconce ;

- la hauteur d'un bâtonnet est comprise entre 1 et 10 micromètres ;

- la plus grande dimension de la face terminale est inférieure à 2 micromètres ;

- la distance qui sépare deux bâtonnets immédiatement adjacents est au minimum égale à 10 micromètres ;

- la dimension de la surface éclairante est d'au plus 8 mm$^2$ ;

- la luminance obtenue par la pluralité de bâtonnets électroluminescents est d'au moins 60Cd/mm$^2$, de préférence d'au moins 80Cd/mm$^2$ ;

- la distance qui sépare deux bâtonnets immédiatement adjacents est comprise entre 2 micromètres et 10 micromètres.

Le flux lumineux et la luminance d'une source lumineuse de la présente invention sont contraints par les réglementations en vigueur concernant l'éclairage et/ou la signalisation dans le domaine automobile et par la diaphonie entre bâtonnets. En outre les architectures électriques actuelles des véhicules automobiles limitent la puissance d'alimentation de la source lumineuse. Ainsi pour obtenir un faisceau d'éclairage et/ou de signalisation conforme à ces règlements avec une telle source lumineuse et dans la limite de ces architectures électriques, les paramètres de la source de lumière de l'invention comme la hauteur et le diamètre des bâtonnets ou en l'occurrence l'espacement des bâtonnets sur le substrat de la source lumineuse peuvent être variés. Il a ainsi été constaté que la distance qui sépare deux bâtonnets immédiatement adjacents doit avantageusement être comprise entre 2 micromètres et 100 micromètres, préférentiellement entre 2 micromètres et 10 micromètres.

D'autre part, cette fourchette permet de fabriquer facilement des optiques de mise en forme dont le pouvoir de résolution permettra de distinguer deux groupes distincts de bâtonnets et ne permettra pas de distinguer deux bâtonnets distincts.

Selon d'autres caractéristiques, on pourra prévoir que la source de lumière à semi-conducteur comprenant une pluralité de bâtonnets électroluminescents de dimensions submillimétriques comporte en outre une couche d'un matériau polymère dans laquelle les bâtonnets sont au moins partiellement noyés ; ce matériau polymère peut être à base de silicone, étant entendu que le matériau polymère est à base de silicone dès lors qu'il comporte majoritairement du silicone, par exemple au moins 50% et dans la pratique environ 99%. La couche de matériau polymère peut comprendre un luminophore ou une pluralité de luminophores excités par la lumière générée par au moins un de la pluralité de bâtonnets. On entend par luminophore, ou convertisseur de lumière, et par exemple un matériau phosphorescent, la présence d'au moins un matériau luminescent conçu pour absorber au moins une partie d'au moins une lumière d'excitation émise par une source lumineuse et pour convertir au moins une partie de ladite lumière d'excitation absorbée en une lumière d'émission ayant une longueur d'onde différente de celle de la lumière d'excitation. Ce luminophore, ou cette pluralité de luminophores, peut être au moins partiellement noyé dans le polymère.

Il est intéressant selon l'invention que les deux sources de lumière présentent des luminances distinctes. Par luminance d'une source de lumière, on entend la luminance globale d'une source, obtenue en considérant l'émission lumineuse maximale par l'ensemble des moyens d'émission de lumière, notamment les bâtonnets électroluminescents, formant cette source de lumière. Ainsi, on associe à la fonction d'éclairage souhaitée une source de lumière adaptée. Dans le cas précisé précédemment, on cherchera à prévoir une zone de luminance plus forte pour le faisceau Route que la luminance du faisceau Code.

A cet effet, on peut prévoir de réaliser les deux sources de lumière avec une pluralité de bâtonnets électroluminescents tel que cela vient d'être décrit précédemment. Chacun des bâtonnets prend naissance sur au moins un substrat, notamment en Silicium. On pourra prévoir avantageusement que le substrat est commun aux deux sources de lumière, ce qui permet de ne prévoir qu'une seule connectique électrique pour l'alimentation des électrodes associées aux sources à semi-conducteur.

Dans chacune de ces sources, tel que cela a pu être précisé, la distance qui sépare deux bâtonnets immédiatement adjacents est par exemple au minimum égale à 10 micromètres. Il est par ailleurs notable que cette distance de séparation entre deux bâtonnets immédiatement adjacents peut être la même entre deux bâtonnets d'une même source de lumière et entre deux bâtonnets de deux sources de lumière adjacentes. On assura ainsi une réalisation jointive des deux sources de lumière, permettant la réalisation d'un faisceau lumineux Route homogène lorsque les deux sources de lumière sont allumées.

Les sources de lumière sont pilotées pour être allumées de manière distincte et l'on prévoit un système de contrôle de l'allumage distinct de ces sources de lumière, étant entendu qu'on entend principalement par cela que les sources de lumière peuvent être allumées ou éteintes distinctivement l'une de l'autre, simultanément ou non. Par ailleurs, on peut prévoir que deux bâtonnets électroluminescents ou deux groupes de bâtonnets d'une même source de lumière soient agencés pour être allumés de manière distincte, étant entendu qu'on entend par cela qu'une ou plusieurs bâtonnets d'une même source de lumière peuvent être pilotés pour jouer sur leur intensité lumineuse.

Notamment dans le cas de deux sources de lumière à bâtonnets électroluminescents, on pourra jouer sur la surface éclairante de chacune des deux sources de lumière en modifiant le nombre de bâtonnets en saillie du substrat associés à l'une ou l'autre des sources, ou en modifiant le nombre de bâtonnets électriquement raccordés entre eux.

Selon l'invention, l'optique de mise en forme peut comprendre une optique de projection de la lumière émise par la source de lumière à semi-conducteur. Cette optique de projection crée une image réelle, et éventuellement anamorphosée, d'une partie du dispositif, par exemple la source elle-même ou un cache, ou d'une image intermédiaire de la source, à distance (finie ou infinie) très grande devant les dimensions du dispositif (d'un rapport de l'ordre d'au moins 30, de préférence 100) du dispositif. Cette optique de projection peut consister en un ou plusieurs réflecteurs, ou bien en une ou plusieurs lentilles, ou encore en une combinaison de ces deux possibilités.

Le dispositif prend ainsi particulièrement place dans un projecteur avant de véhicule automobile, apte à émettre une première fonction d'éclairage qui soit une fonction de feu Code et une deuxième fonction d'éclairage qui soit une fonction de feu Route.

D'autres caractéristiques et avantages de la présente invention apparaîtront plus clairement à l'aide de la description et des dessins parmi lesquels :

- la figure 1 est une vue en coupe d'un dispositif lumineux selon l'invention, dans lequel on a illustré des rayons lumineux émis par deux sources de lumière à semi-conducteur, au moins l'une d'entre elles comprenant des bâtonnets électroluminescents, lesdits rayons étant déviés par une optique de mise en forme des rayons en deux faisceaux chacun spécifique à une fonction d'éclairage ;

- la figure 2 est une représentation schématique en perspective d'un dispositif émetteur de lumière à deux sources de lumière à semi-conducteur selon un mode de réalisation de l'invention, dans lequel chaque source de lumière comporte des bâtonnets électroluminescents ;

- la figure 3 est une représentation schématique en perspective d'un dispositif émetteur de lumière à deux sources de lumière à semi-conducteur, dans laquelle on a rendu visible en coupe une rangée de bâtonnets électroluminescents ;

- la figure 4 est une vue en coupe d'un mode de réalisation particulier de l'invention, dans lequel deux bâtonnets électroluminescents s'étendent en saillie d'un substrat, lesdits bâtonnets électroluminescents étant encapsulés dans une couche protectrice ;

- les figures 5a et 5b sont des illustrations des faisceaux projetés à l'infini par le dispositif de l'invention, la figure 5a illustrant un faisceau correspondant au feu d'éclairage de type code et la figure 5b illustrant un faisceau correspondant au feu d'éclairage de type route ;

- la figure 6 est un graphe représentatif de la luminance et du contraste de la lumière émise par une source à semi-conducteur du dispositif émetteur de lumière pour réaliser un feu d'éclairage de type code ;

- et la figure 7 est un graphe représentatif de la luminance de la lumière émise par le dispositif émetteur de lumière lorsque les deux sources à semi-conducteur sont activées pour réaliser un feu d'éclairage de type route.

Un dispositif lumineux d'un véhicule automobile comporte un dispositif émetteur de lumière 1, notamment logé dans un boîtier fermé par une glace et qui définit un volume interne de réception de ce dispositif émetteur. Le dispositif émetteur de lumière est associé à une optique de mise en forme 2 d'au moins une partie des rayons lumineux émis par le dispositif émetteur de lumière en sortie du boitier du dispositif lumineux.

Tel que cela a été précisé précédemment, un dispositif lumineux s'entend aussi bien par un dispositif d'éclairage intérieur, un dispositif d'éclairage extérieur ou par un dispositif de signalisation. Dans l'exemple qui va être plus précisément décrit, on se rapporte à titre non limitatif à une fonction d'éclairage extérieur du véhicule.

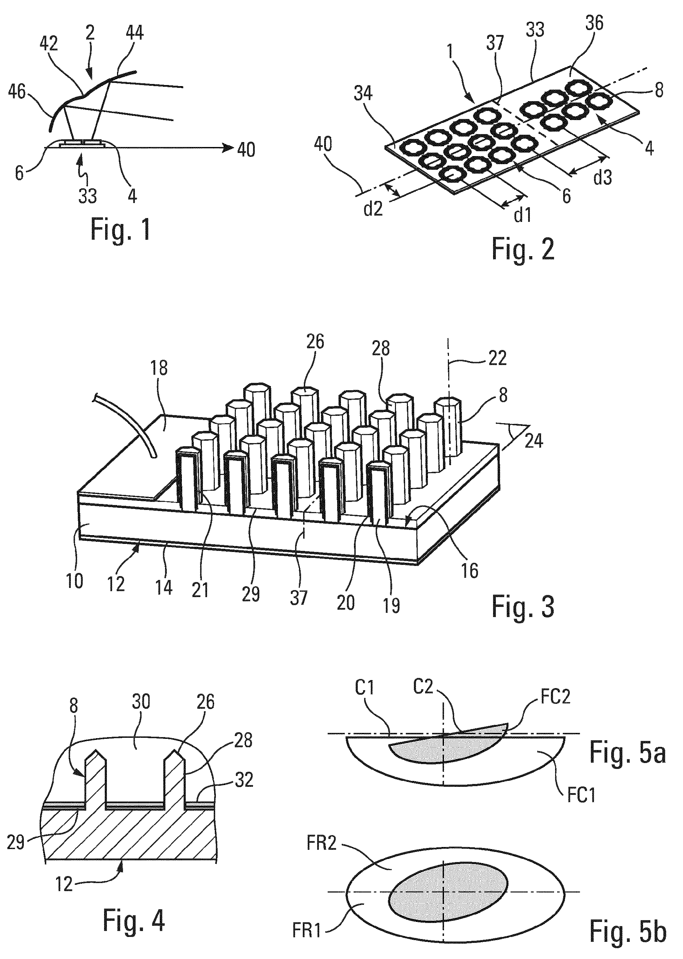

Le dispositif émetteur de lumière est ici agencé de manière à former deux sources de lumière distinctes 4, 6, et notamment distinctes en ce que la luminance d'une première source de lumière 4 est plus forte que la luminance de l'autre des deux sources de lumière 6. Au moins une de ces sources de lumière est une source à semi-conducteur, comportant des bâtonnets électroluminescents de dimensions submillimétriques. Selon différentes variantes de réalisation, il peut être prévu (tel qu'illustré à titre d'exemple sur la figure 2) que les deux sources de lumière 4, 6 comportent des bâtonnets électroluminescents de dimensions submillimétriques, c'est-à-dire des sources à semi-conducteurs en trois dimensions tel que cela sera exposé ci-après, ou bien que (tel qu'illustré à titre d'exemple sur la figure 1) seule une des sources de lumière à semi-conducteur 4 comporte des bâtonnets électroluminescents de dimensions submillimétriques, tandis que l'autre source de lumière 6 est par exemple une diode électroluminescente (DEL), c'est-à-dire une source à semi-conducteur en deux dimensions, assimilée à une source sensiblement plane du fait de la planéité des couches émettrices. Dans une variante préférée, telle qu'elle sera décrite ci-après, les deux sources de lumière comportent des bâtonnets électroluminescents et un substrat de ces bâtonnets électroluminescents est commun à ces deux sources.

On va maintenant décrire la structure d'une source de lumière 4 à semi-conducteurs comportant des bâtonnets électroluminescents de dimensions submillimétriques, notamment en se référant aux figures 3 et 4.

La source de lumière 4 comprend une pluralité de bâtonnets électroluminescents 8 qui prennent naissance sur au moins un substrat 10. Chaque bâtonnet électroluminescent, ici formé par utilisation de nitrure de gallium (GaN), s'étend perpendiculairement, ou sensiblement perpendiculairement, en saillie du substrat, ici réalisé à base de silicium ou de carbure de silicium d'autres matériaux pouvant être utilisés sans sortir du contexte de l'invention. A titre d'exemple, les bâtonnets électroluminescents pourraient être réalisés à partir d'un composé à base de nitrure d'aluminium et de nitrure de gallium (AlN/GaN), ou à partir d'un composé à base d'aluminium, d'indium et de gallium.

Le substrat 10 présente une face inférieure 12, sur laquelle est rapportée une première électrode 14, et une face supérieure 16, en saillie de laquelle s'étendent les bâtonnets électroluminescents 8 et sur laquelle est rapportée une deuxième électrode 18. Différentes couches de matériaux sont superposées sur la face supérieure 16, notamment après la croissance des bâtonnets électroluminescents depuis le substrat ici obtenue par une approche ascendante. Parmi ces différentes couches, on peut trouver au moins une couche de matériau conducteur électriquement, afin de permettre l'alimentation électrique des bâtonnets. Cette couche est gravée de manière à relier tel ou tel bâtonnet entre eux, l'allumage de ces bâtonnets électroluminescents pouvant alors être commandé simultanément par un module de commande ici non représenté. On pourra prévoir qu'au moins deux bâtonnets électroluminescents ou au moins deux groupes de bâtonnets électroluminescents sont agencés pour être allumés de manière distincte, i.e. de manière sélective, par l'intermédiaire d'un système de contrôle de l'allumage.

Les bâtonnets électroluminescents s'étirent depuis le substrat et, tel que cela est visible sur la figure 3, ils comportent chacun un noyau 19 en nitrure de gallium, autour duquel sont disposés des puits quantiques 20 formés par une superposition radiale de couches de matériaux différents, ici du nitrure de gallium et du nitrure de gallium-indium, et une coque 21 entourant les puits quantiques également réalisé en nitrure de gallium.

Chaque bâtonnet électroluminescent s'étend selon un axe longitudinal 22 définissant sa hauteur, la base 23 de chaque bâtonnet étant disposée dans un plan 24 de la face supérieure 16 du substrat 10.

Les bâtonnets électroluminescents 8 d'une même source de lumière présentent avantageusement la même forme. Ils sont chacun délimités par une face terminale 26 et par une paroi circonférentielle 28 qui s'étend le long de l'axe longitudinal. Lorsque les bâtonnets électroluminescents sont dopés et font l'objet d'une polarisation, la lumière résultante en sortie de la source à semi-conducteurs est émise essentiellement à partir de la paroi circonférentielle 28, étant entendu que des rayons lumineux peuvent sortir également de la face terminale 26. Il en résulte que chaque bâtonnet électroluminescent agit comme une unique diode électroluminescente et que la densité des bâtonnets électroluminescents 8 présents pour une source de lumière 4 améliore le rendement lumineux de cette source.

La paroi circonférentielle 28 d'un bâtonnet électroluminescent 8, correspondant à la coquille de nitrure de gallium, est recouverte par une couche d'oxyde conducteur transparent (TCO) 29 qui forme l'anode de chaque bâtonnet complémentaire à la cathode formée par le substrat. Cette paroi circonférentielle 28 s'étend le long de l'axe longitudinal 22 depuis le substrat 10 jusqu'à la face terminale 26, la distance de la face terminale 26 à la face supérieure 16 du substrat, depuis laquelle prennent naissance les bâtonnets électroluminescents 8, définissant la hauteur de chaque bâtonnet. A titre d'exemple, on prévoit que la hauteur d'un bâtonnet électroluminescent 8 est comprise entre 1 et 10 micromètres, tandis que l'on prévoit que la plus grande dimension transversale de la face terminale, perpendiculairement à l'axe longitudinal 22 du bâtonnet concerné, soit inférieure à 2 micromètres. On pourra également prévoir de définir la surface d'un bâtonnet, dans un plan de coupe perpendiculaire à cet axe longitudinal 22, dans une plage de valeurs déterminées, et notamment entre 1.96 et 4 micromètres carré.

On comprend que lors de la formation des bâtonnets électroluminescents 8, la hauteur peut être modifiée d'une source de lumière à l'autre, de manière à accroitre la luminance de la source de lumière lorsque la hauteur est augmentée. Ainsi, un groupe de bâtonnets électroluminescents peut avoir une hauteur, ou des hauteurs, différentes d'un autre groupe de bâtonnets électroluminescents, ces deux groupes étant constitutifs de la même source de lumière à semi-conducteur comprenant des bâtonnets électroluminescents de dimensions submillimétriques.

La forme des bâtonnets électroluminescents 8 peut également varier d'un dispositif à l'autre, notamment sur la section des bâtonnets et sur la forme de la face terminale 26. Il a été illustré sur les figures 1 et 2 des bâtonnets électroluminescents de section circulaire, et sur la figure 3 des bâtonnets électroluminescents 8 présentant une forme de section polygonale, et plus particulièrement hexagonale. On comprend qu'il importe que de la lumière puisse être émise à travers la paroi circonférentielle, que celle-ci présente une forme polygonale ou circulaire.

Par ailleurs, la face terminale 26 peut présenter une forme sensiblement plane et perpendiculaire à la paroi circonférentielle, de sorte qu'elle s'étend sensiblement parallèlement à la face supérieure 16 du substrat 10, tel que cela est illustré sur la figure 3, ou bien elle peut présenter une forme bombée ou en pointe en son centre, de manière à multiplier les directions d'émission de la lumière sortant de cette face terminale, tel que cela est illustré sur la figure 4.

Sur les figures 2 et 3, les bâtonnets électroluminescents 8 sont agencés en matrice à deux dimensions. Cet agencement pourrait être tel que les bâtonnets soient agencés en quinconce. L'invention couvre d'autres répartitions des bâtonnets électroluminescents, avec notamment des densités de bâtonnets qui peuvent être variables d'une source de lumière à l'autre, et qui peuvent être variables selon différentes zones d'une même source de lumière. On a représenté sur la figure 2 la distance de séparation d1 de deux bâtonnets électroluminescents immédiatement adjacents dans une première direction transversale et la distance de séparation d2 de deux bâtonnets électroluminescents immédiatement adjacents dans une deuxième direction transversale. Les distances de séparation d1 et d2 sont mesurées entre deux axes longitudinaux 20 de colonnes adjacentes. Le nombre de bâtonnets électroluminescents 8 s'étendant en saillie du substrat 10 peut varier d'un dispositif à l'autre, notamment pour augmenter la densité lumineuse de la source de lumière, mais on convient que l'une ou l'autre des distances de séparation d1, d2 doit être au minimum égale à 10 micromètres, afin que la lumière émise par la paroi circonférentielle 28 de chaque bâtonnet8 puisse sortir de la matrice de bâtonnets électroluminescents.

La source de lumière 4 à semi-conducteur peut comporter en outre, tel qu'illustré sur la figure 4, une couche 30 d'un matériau polymère dans laquelle les bâtonnets électroluminescents 8 sont au moins partiellement noyées. La couche 30 peut ainsi s'étendre sur toute l'étendue du substrat ou seulement autour d'un groupe déterminé de bâtonnets électroluminescents 8. Le matériau polymère, qui peut notamment être à base de silicone, crée une couche protectrice qui permet de protéger les bâtonnets électroluminescents 8 sans gêner la diffusion des rayons lumineux. En outre, il est possible d'intégrer dans cette couche 30 de matériau polymère des moyens de conversion de longueur d'onde, et par exemple des luminophores, aptes à absorber au moins une partie des rayons émis par l'un des bâtonnets et à convertir au moins une partie de ladite lumière d'excitation absorbée en une lumière d'émission ayant une longueur d'onde différente de celle de la lumière d'excitation.

La source de lumière peut comporter en outre un revêtement 32 de matériau réfléchissant la lumière qui est disposé entre les bâtonnets électroluminescents 8 pour dévier les rayons, initialement orientés vers le substrat, vers la face terminale 26 des bâtonnets électroluminescents 8. En d'autres termes, la face supérieure 16 du substrat 10 peut comporter un moyen réfléchissant qui renvoie les rayons lumineux, initialement orientés vers la face supérieure 16, vers la face de sortie de la source de lumière. On récupère ainsi des rayons qui autrement seraient perdus. Ce revêtement 32 est disposé entre les bâtonnets électroluminescents 8 sur la couche d'oxyde conducteur transparent 29.

On va maintenant décrire un dispositif lumineux comportant un dispositif émetteur formé de deux sources de lumière à semi-conducteurs comportant des bâtonnets électroluminescents et une optique de mise en forme de la lumière émise par l'une et/ou l'autre des sources de lumière en vue de générer au moins deux fonctions d'éclairage et/ou de signalisation.

Le dispositif émetteur de lumière 1 comporte ici une forme rectangulaire, mais on comprendra qu'il peut présenter sans sortir du contexte de l'invention d'autres formes générales, et notamment une forme de parallélogramme.

Sur les figures 2 et 3, le dispositif émetteur de lumière 1 présente une partie émettrice 33 divisée en deux zones jointives, parmi lesquelles une première zone 34 et une deuxième zone 36, ces deux zones étant disposées en série le long de l'axe optique 40 défini par ledit dispositif émetteur et l'optique de mise en forme. La première zone 34 est disposée plus en avant que la deuxième zone 36 par rapport à l'axe optique 40 et la direction principale d'émission des rayons, c'est-à-dire qu'elle se situe sur l'axe optique, par rapport à la deuxième zone, plus proche de la sortie du dispositif lumineux. La séparation 37 entre les deux zones 34, 36 suit ici la forme d'une portion de droite. Tel que cela sera décrit plus en détails ci-après, cette séparation 37 peut être obtenue par la réalisation physique d'un muret s'étendant en saillie du substrat, mais elle est en premier lieu réalisée par le câblage déterminé de tel ou tel bâtonnet 8 entre eux.

Dans chacune de ces zones 34,36 est disposée une source de lumière à semi-conducteur à bâtonnets électroluminescents de dimensions submillimétriques 4,6, ces deux sources de lumière à semi-conducteur étant connectées électriquement pour être activables sélectivement, de part et d'autre de la séparation 37. On a représenté sur la figure 2 la distance de séparation d3, dans la première direction transversale, entre un bâtonnet d'une première source de lumière à semi-conducteur 4 et un bâtonnet directement adjacent et d'une deuxième source de lumière à semi-conducteur 6. On convient que cette distance de séparation d3, mesurée entre deux axes longitudinaux de bâtonnets électroluminescents, doit être au minimum égale à 10 micromètres, afin que la lumière émise par la paroi circonférentielle 28 de chaque colonne 8 puisse sortir de la matrice de bâtonnets électroluminescents, et on cherche à avoir une distance de séparation d3 entre deux bâtonnets de deux sources différentes qui est sensiblement égale à la distance de séparation d1 ou d2 de deux bâtonnets d'une même source de lumière.

Il est intéressant de prévoir que les deux sources de lumière à semi-conducteur présentent des luminances distinctes, notamment dans le cadre d'une application à un dispositif « bi-fonction », c'est-à-dire capable d'effectuer deux fonctions d'éclairage distinctes. Dans la description qui suit, on s'attarde plus particulièrement sur une application préférée dans laquelle le dispositif peut effectuer une première fonction d'éclairage de type code et une deuxième fonction d'éclairage de type route. Plusieurs distinctions peuvent être faites entre les deux zones de la surface émettrice, respectivement associées à l'une ou l'autre des fonctions d'éclairage, étant entendu que dans cette application, on souhaite que l'activation de la première source de lumière à semi-conducteur 4 disposée dans la première zone 34 permette la réalisation de la première fonction d'éclairage, c'est-à-dire l'émission d'un faisceau code, qui nécessite donc une luminance modérée mais un fort flux, tandis que l'activation de la deuxième source à semi-conducteur 6 permet la réalisation de la deuxième fonction d'éclairage, c'est à dire l'émission d'un faisceau route, qui nécessite donc une forte luminance, mais avec un flux modéré. On pourra prévoir, sans sortir du contexte de l'invention, que la deuxième fonction d'éclairage est réalisée uniquement par l'activation de la deuxième source à semi-conducteur 6, tandis que la première source à semi-conducteur 4 est éteinte, ou bien que cette deuxième fonction d'éclairage est réalisée par l'activation simultanée des première et deuxième sources à semi-conducteur, l'activation de la deuxième source à semi-conducteur 6 générant un faisceau complémentaire au faisceau formé par la première source 4 pour réaliser par combinaison le faisceau de type route.

Sur la figure 2, les deux zones émettrices n'ont pas la même taille et elles ne présentent pas le même nombre de bâtonnets électroluminescents de dimensions submillimétriques. De préférence, la première zone est plus grande que la deuxième zone, dans la direction de l'axe optique 40 défini précédemment, dans un rapport allant sensiblement du simple au double

La densité des bâtonnets électroluminescents de dimensions submillimétriques 8 dans chacune des sources à semi-conducteur est avantageusement différente. On pourra prévoir une répartition des bâtonnets différente, ou sensiblement différente, dans chacune des zones, ou bien une répartition des bâtonnets identique, ou sensiblement identique, dans chacune des zones, les bâtonnets pouvant dans ce cas être raccordés électriquement dans leur ensemble ou non selon une source de lumière ou l'autre. On prévoit avantageusement une densité de bâtonnets électroluminescents plus importante pour la deuxième zone 36 associée à la deuxième source de lumière 6, allumée uniquement lorsqu'une fonction d'éclairage de type route est nécessaire.

La hauteur des bâtonnets 8 d'une source de lumière à l'autre est également avantageusement différente. On modifie ainsi la surface d'émission de lumière en augmentant la hauteur de la paroi circonférentielle 28 et on augmente la luminance de la deuxième source de lumière 6 par rapport à la première source de lumière 4 en augmentant la hauteur d'au moins un des bâtonnets électroluminescents de dimensions submillimétriques dans la première zone 34 portant la première source de lumière 4.

On comprend que l'on pourra choisir parmi l'une ou l'autre de ces options pour prévoir une deuxième source de lumière 6 à la luminance plus forte que la luminance de la première source de lumière 4, ou bien que l'on pourra toutes les utiliser, étant entendu que d'autres moyens pour jouer sur la luminance pourrait être utilisés.

Sur la figure 3, le substrat est commun aux deux sources de lumière à semi-conducteur à nanofils. On optimise ainsi le nombre de fils de raccordement électriques, et on facilite le rapprochement l'une de l'autre des deux sources de lumière, le caractère jointif de cet agencement étant particulièrement intéressant pour l'obtention d'un flux homogène lorsque les deux sources de lumière à semi-conducteur sont activées simultanément.

L'optique de mise en forme des rayons lumineux 2 consiste dans l'exemple illustré en un réflecteur 42, qui présente deux zones distinctes 44 et 46, chacune étant apte à recevoir la lumière issue des deux zones distinctes de la partie émettrice. La première zone 44 du réflecteur reçoit les rayons émis par la première zone 34 de la partie émettrice pour former en sortie du dispositif lumineux un premier faisceau et la deuxième zone 46 du réflecteur reçoit les rayons émis par la deuxième zone 36 de la partie émettrice pour former en sortie du dispositif lumineux un deuxième faisceau. On comprend que cette répartition est théorique et qu'il faut prévoir dans les faits que la première zone 44 du réflecteur participe également à la réflexion des rayons émis par la deuxième zone 36 de la partie émettrice et inversement que la deuxième zone 46 du réflecteur participe également à la réflexion des rayons émis par la première zone 34 de la partie émettrice. En variante, il s'agit par exemple d'une seule et même zone éclairée par les deux zones 34 et 36, mais avec par exemple la première zone 34 focalisée et la deuxième zone 36 défocalisée.

Les deux zones 34, 36 de la partie émettrice sont activables sélectivement l'une de l'autre. On pourra notamment prévoir que la deuxième zone, lorsqu'elle est activée, émet des rayons qui forment après réflexion par les moyens de projection un deuxième faisceau complémentaire du premier faisceau projeté par les moyens de projection lorsque c'est la deuxième zone de la partie émettrice qui est activée. On entend par faisceau complémentaire un faisceau qui forme avec le faisceau réalisé par la première source de lumière à semi-conducteur un faisceau cohérent lorsque les deux sources sont pilotées pour réaliser simultanément l'émission du faisceau lumineux qui leur est propre. Ces deux faisceaux complémentaires se superposent pour former un faisceau lumineux réglementaire pour véhicule automobile, c'est-à-dire par exemple un faisceau code/route formé par une zone code et une zone route ou par exemple un faisceau code formé par une première zone code et une deuxième zone code.

Tel que cela a pu être précisé précédemment, on va décrire plus particulièrement le cas où la première zone 34 de la partie émettrice correspond à une zone Code (ZC) tandis que la deuxième zone 36 de la partie émettrice correspond à une zone Route (ZR). Les deux zones de la partie émettrice sont activables sélectivement l'une de l'autre et l'on prévoit d'activer seulement la première zone 34, dite zone Code, pour former un feu d'éclairage correspondant à un faisceau de feu Code, c'est-à-dire un faisceau de feux de croisement apte à ne pas éblouir les occupants d'un autre véhicule (faisceau visible sur la figure 4a) et d'activer les deux zones, celle dite zone Code et celle dite zone Route, pour former un feu d'éclairage de type route, ou plein feux. On comprend qu'une unique source de lumière à semi-conducteur 4 génère des rayons de lumière participant à la formation d'un faisceau de feu de croisement, alors que les deux sources de lumière à semi-conducteur 4,6 génèrent ensemble des rayons de lumière participant à la formation d'un faisceau de feu de route. On pourrait également envisager, tel que cela a été décrit précédemment, qu'une source de lumière à semi-conducteur est strictement associé à une première fonction d'éclairage et que l'autre source de lumière à semi-conducteur est strictement associée à une deuxième fonction d'éclairage.

Tel que cela est illustré sur la figure 5a, lorsque la première zone de la partie émettrice est activée seule, la première zone 44 de la partie émettrice produit un premier sous-faisceau FC1 présentant une coupure plate horizontale c1 tandis que la deuxième zone 46 de la partie émettrice produit un second sous-faisceau FC2 présentant une coupure plate oblique c2. Les faisceaux FC1 et FC2 se superposent pour former le faisceau correspondant au feu d'éclairage de type code. On peut prévoir que les coupures c1 et c2 forment entre elles un angle compris entre 10 et 60 degrés, de préférence compris entre 15 et 45 degrés.

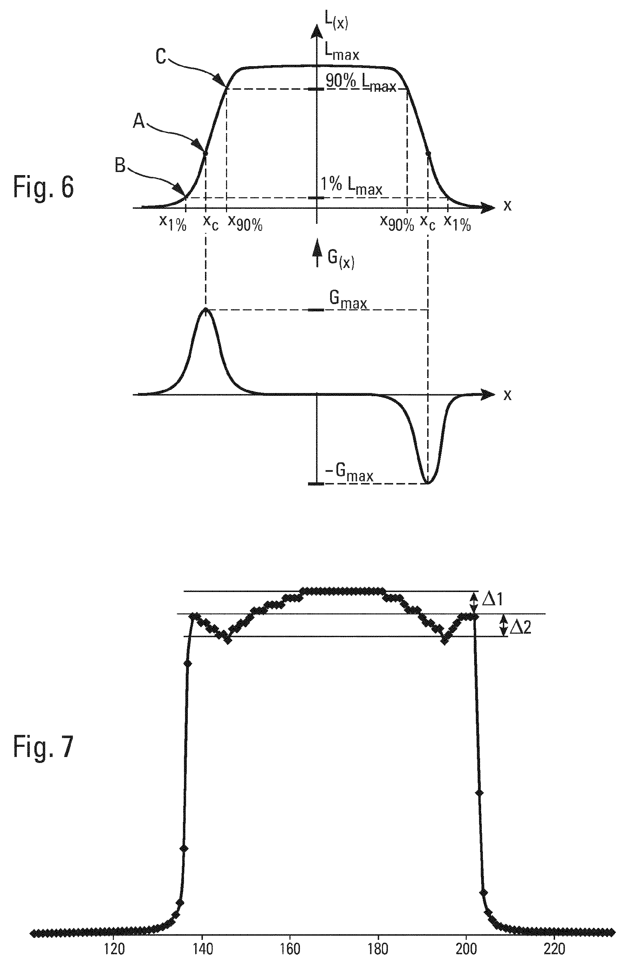

Afin que le faisceau Code soit réglementaire, la coupure doit présenter un contraste suffisant. On a illustré sur la figure 6 une carte de luminance représentant la lumière émise par la zone code et une représentation des valeurs de contraste $G(x)$ définies par la fonction d'équation ;

$$G(x) = \text{Log10}[\, L(x) \,] - \text{Log10}\,[\, L(x+\text{step}) \,].$$

On vise à ce qu'une valeur d'écart entre le maximum de contraste (point A) et le niveau 1% de la luminance maximale (point B) n'excède pas 0,2mm et de préférence, elle ne doit pas excéder 0,1m.

Par ailleurs, afin de garantir une bonne portée d'éclairage en Code, le maximum d'intensité en Code doit être placé au plus près sous la coupure, ce qui se traduit, sur la carte de luminance de la figure 6, par une distance maximale de 0,03mm entre le maximum de contraste (point A) et le niveau 90% de la luminance maximale (point C), étant entendu que la modélisation est faite dans le cas d'émetteurs de type lambertien.

Tel que cela est illustré sur la figure 5b, lorsque les deux zones de la partie émettrice sont alimentées simultanément, la zone 44 du réflecteur forme un faisceau large et homogène FR1 semblable au faisceau illustré sur la figure 5a, et la zone 46 du réflecteur forme un faisceau concentré et homogène FR2 qui se superpose au premier.

On comprend que la séparation entre la première zone 34 et la deuxième zone 36 du dispositif émetteur de lumière est non émettrice, la séparation pouvant être formée par un mur opaque s'étendant en saillie du substrat entre les bâtonnets électroluminescents disposés à la bordure de chaque zone. Cette séparation crée dans le faisceau Route, obtenu par l'émission combinée des deux zones 34,36 de la partie émettrice, une zone assombrie par rapport au reste. Afin d'avoir un faisceau Route le plus homogène possible, il est important que cette zone assombrie soit réduite au maximum, c'est-à-dire que les zones 34,36 soient le plus jointives possibles. Ce qui se traduit, sur une carte de luminance telle qu'illustrée sur la figure 6 et représentant la lumière émise lorsque les deux zones 34,36 sont activées simultanément, à un écart de moins de 10% par rapport à la moyenne de la luminance maximale, sur une plage où la luminance est supérieure à 90%, étant entendu que là encore, la modélisation est faite dans le cas d'émetteurs de type lambertien.

La présente invention s'applique tout particulièrement à un projecteur avant de véhicule automobile.

La description qui précède explique clairement comment l'invention permet d'atteindre les objectifs qu'elle s'est fixés et notamment de proposer un dispositif lumineux qui permette de réaliser à moindre coût, et sans perte de qualité photométrique, un éclairage bi-fonction, c'est-à-dire un éclairage différent avec une unique optique de mise en forme. On comprend qu'il a été plus particulièrement décrit une application à un dispositif bi-fonction permettant de réaliser un éclairage de type code et un éclairage de type route, mais que le dispositif pourrait aisément être appliqué pour réaliser des fonctions différentes pouvant inclure notamment une fonction d'éclairage diurne.

Bien entendu, diverses modifications peuvent être apportées par l'homme du métier à la structure du dispositif lumineux qui vient d'être décrite à titre d'exemple non limitatif, dès lors qu'elle utilise au moins une source de lumière à semi-conducteur à bâtonnets électroluminescents, notamment pour jouer facilement sur des variations d'une source à l'autre de la luminance. En tout état de cause, l'invention ne saurait se limiter au mode de réalisation spécifiquement décrit dans ce document, et s'étend en particulier à tous moyens équivalents et à toute combinaison techniquement opérante de ces moyens.

A titre d'exemple, certaines variantes non représentées sont décrites ci-dessous, sans que cette liste soit pour autant exhaustive :

- l'optique de mise en forme des rayons lumineux ne consiste pas en un réflecteur comme décrit précédemment, mais il consiste en au moins une lentille ou en une combinaison de réflecteur(s) et de lentille(s).
- les deux zones de la partie émettrice ont des dimensions sensiblement égales, étant entendu que comme précédemment, les rayons émis distinctement par la première et la deuxième zone sont déviés par l'optique de mise en forme pour la réalisation de deux faisceaux d'éclairage et/ou de signalisation distincts.

## Revendications

1. Dispositif lumineux pour véhicule automobile, comprenant au moins une première et une deuxième sources de lumière (4, 6) à semi-conducteur activable sélectivement et au moins une optique de mise en forme (2) de la lumière émise par l'une et/ou l'autre desdites première et deuxième sources de lumière à semi-conducteur en vue de générer au moins deux fonctions d'éclairage et/ou de signalisation, le dispositif étant configuré de telle sorte qu'une première fonction nécessite l'activation de la première source de lumière à semi-conducteur (4) et qu'une deuxième fonction nécessite l'activation de la deuxième source de lumière à semi-conducteur (6), au moins la deuxième source comprenant une pluralité de bâtonnets électroluminescents (8) de dimensions submillimétriques.

2. Dispositif selon la revendication 1, **caractérisé en ce que** la deuxième fonction d'éclairage et/ou de signalisation nécessite uniquement l'activation de la deuxième source de lumière (6) à semi-conducteur.

3. Dispositif selon la revendication 2, **caractérisé en ce que** la deuxième fonction d'éclairage et/ou de signalisation génère la formation d'un faisceau de feu de type antibrouillard.

4. Dispositif selon la revendication 2, **caractérisé en ce que** la deuxième fonction d'éclairage et/ou de signalisation génère la formation d'un faisceau de feu de type code.

5. Dispositif selon la revendication 1, **caractérisé en ce que** la deuxième fonction d'éclairage et/ou de signalisation nécessite l'activation simultanée de la première source de lumière à semi-conducteur et de la deuxième source de lumière à semi-conducteur.

6. Dispositif selon la revendication précédente, **caractérisé en ce que** la deuxième fonction d'éclairage et/ou de signalisation génère la formation d'un faisceau de feu de type route.

7. Dispositif selon la revendication précédente, **caractérisé en ce que** la première fonction d'éclairage et/ou de signalisation génère la formation d'un faisceau de feu de type code.

8. Dispositif selon l'une des revendications précédentes, dans lequel les bâtonnets électroluminescents (8) sont sur un même substrat (10).

9. Dispositif selon l'une quelconque des revendications précédentes, dans lequel les bâtonnets électroluminescents (8) présentent une forme générale cylindrique, notamment de section polygonale.

**10.** Dispositif selon l'une des revendications précédentes, **caractérisé en ce que** la hauteur d'un bâtonnet électroluminescent (8) est comprise entre 1 et 10 micromètres.

**11.** Dispositif selon l'une des revendications précédentes, **caractérisé en ce que** les bâtonnets électroluminescents (8) sont chacun délimités par une face terminale (26) et par une paroi circonférentielle (28) qui s'étend le long d'un axe longitudinal (23) du bâtonnet définissant sa hauteur, la lumière étant émise au moins à partir de la paroi circonférentielle.

**12.** Dispositif selon la revendication précédente, **caractérisé en ce que** la plus grande dimension de la face terminale (26) est inférieure à 10 micromètres, de préférence inférieure à 5 micromètres.

**13.** Dispositif selon l'une quelconque des revendications précédentes, **caractérisé en ce que** les deux sources de lumière (4, 6) à semi-conducteur présentent des luminances distinctes.

**14.** Dispositif selon l'une quelconque des revendications précédentes, **caractérisé en ce que** la distance (d1, d2, d3) qui sépare deux bâtonnets électroluminescents (8) immédiatement adjacents est au minimum égale à 2 micromètres et au maximum égale à 100 micromètres.

**15.** Dispositif selon la revendication précédente, **caractérisé en ce qu'**une distance (d3) qui sépare deux bâtonnets électroluminescents (8) de deux sources de lumière adjacentes est égale à la distance (d1, d2) qui sépare deux bâtonnets électroluminescents (8) immédiatement adjacentes d'une même source.

Fig. 1

Fig. 2

Fig. 3

Fig. 4

Fig. 5a

Fig. 5b

Fig. 6

Fig. 7

Europäisches
Patentamt

European
Patent Office

Office européen
des brevets

# RAPPORT DE RECHERCHE EUROPEENNE

Numéro de la demande

EP 16 18 2819

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | EP 2 363 320 A1 (AUTOMOTIVE LIGHTING REUTLINGEN [DE]) 7 septembre 2011 (2011-09-07) * revendications 1-11; figures 1-4 * * alinéas [0001], [0003], [0008], [0030] * | 1-3,5, 8-15 | INV. B60Q1/28 F21S8/10 H01L33/08 H01L33/24 F21Y105/00 F21Y105/10 F21Y105/12 |
| Y | US 2015/155432 A1 (YOO GEON WOOK [KR] ET AL) 4 juin 2015 (2015-06-04) * revendication 1; figures 1-8 * * alinéa [0023] * | 1-3,5, 8-15 | |
| Y | EP 2 752 615 A1 (KOITO MFG CO LTD [JP]) 9 juillet 2014 (2014-07-09) * alinéas [0020], [0094] - [0104], [0131] - [0142] * | 1-15 | |
| Y | WO 2010/014032 A1 (GLO AB [SE]; KONSEK STEVEN LOUIS [SE]; OHLSSON JONAS [SE]; MARTYNOV YO) 4 février 2010 (2010-02-04) * revendications 1-14; figures 1-9 * * page 10 * | 1-15 | DOMAINES TECHNIQUES RECHERCHES (IPC) |
| A | EP 2 058 585 A2 (ZIZALA LICHTSYSTEME GMBH [AT]) 13 mai 2009 (2009-05-13) * figures 1-15 * * alinéas [0041], [0042], [0052], [0057] * | 1-15 | B60Q F21S F21Y H01L |
| A | WO 2009/144024 A1 (OSRAM GMBH [DE]; HERING OLIVER [DE]; HERRMANN JENNY [DE]; REINERS THOM) 3 décembre 2009 (2009-12-03) * revendication 1; figures 1-7 * * pages 13,20 * | 1-7,13 | |

Le présent rapport a été établi pour toutes les revendications

| Lieu de la recherche | Date d'achèvement de la recherche | Examinateur |
|---|---|---|
| Munich | 23 novembre 2016 | Giraud, Pierre |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
 
& : membre de la même famille, document correspondant

EPO FORM 1503 03.82 (P04C02)

## ANNEXE AU RAPPORT DE RECHERCHE EUROPEENNE
### RELATIF A LA DEMANDE DE BREVET EUROPEEN NO.

EP 16 18 2819

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-11-2016

| Document brevet cité au rapport de recherche | | Date de publication | Membre(s) de la famille de brevet(s) | | Date de publication |
|---|---|---|---|---|---|
| EP 2363320 | A1 | 07-09-2011 | DE 102010009640 A1<br>EP 2363320 A1 | | 01-09-2011<br>07-09-2011 |
| US 2015155432 | A1 | 04-06-2015 | KR 20150064413 A<br>US 2015155432 A1 | | 11-06-2015<br>04-06-2015 |
| EP 2752615 | A1 | 09-07-2014 | CN 103765086 A<br>CN 105351839 A<br>CN 105351840 A<br>EP 2752615 A1<br>EP 3056385 A1<br>EP 3056803 A1<br>US 2014175978 A1<br>WO 2013031210 A1 | | 30-04-2014<br>24-02-2016<br>24-02-2016<br>09-07-2014<br>17-08-2016<br>17-08-2016<br>26-06-2014<br>07-03-2013 |
| WO 2010014032 | A1 | 04-02-2010 | CN 102089893 A<br>CN 103022282 A<br>EP 2297794 A1<br>JP 5836122 B2<br>JP 2011527519 A<br>KR 20110039313 A<br>US 2011254034 A1<br>US 2014239327 A1<br>WO 2010014032 A1 | | 08-06-2011<br>03-04-2013<br>23-03-2011<br>24-12-2015<br>27-10-2011<br>15-04-2011<br>20-10-2011<br>28-08-2014<br>04-02-2010 |
| EP 2058585 | A2 | 13-05-2009 | AT 506003 A1<br>EP 2058585 A2 | | 15-05-2009<br>13-05-2009 |
| WO 2009144024 | A1 | 03-12-2009 | CN 102046420 A<br>DE 102008025397 A1<br>EP 2300269 A1<br>JP 5611941 B2<br>JP 2011521435 A<br>KR 20110013503 A<br>US 2011080753 A1<br>WO 2009144024 A1 | | 04-05-2011<br>24-12-2009<br>30-03-2011<br>22-10-2014<br>21-07-2011<br>09-02-2011<br>07-04-2011<br>03-12-2009 |

EPO FORM P0460

Pour tout renseignement concernant cette annexe : voir Journal Officiel de l'Office européen des brevets, No.12/82